# EUROPÄISCHE PATENTSCHRIFT

(11) **EP 0 529 176 B1**
(45) Veröffentlichungstag und Bekanntmachung des Hinweises auf die Patenterteilung: **22.02.1995**
(21) Anmeldenummer: 91810681.6
(22) Anmeldetag: 26.08.1991
(51) Int. Cl.: G01J 1/44

(54) **Verfahren und Vorrichtung zur Messung kleiner Lichtmengen**
Method and apparatus for measuring small quantities of light
Procédé et dispositif pour mesurer de petites quantités de lumière

(43) Veröffentlichungstag der Anmeldung: 03.03.1993
(73) Patentinhaber: GRETAG IMAGING AG, CH-8105 Regensdorf (CH)
(72) Erfinder: Schenkel, Paul, CH-8105 Watt (CH); Frick, Beat, Dr., CH-8107 Buchs (CH)
(74) Vertreter: Kleewein, Walter, Dr.

(56) Entgegenhaltungen:
- EP-A- 0 055 027
- WO-A-90/06492
- DE-A- 2 446 610

## Beschreibung

Die Erfindung betrifft ein Verfahren und eine Vorrichtung zur Messung kleiner Lichtmengen gemäss dem Oberbegriff des jeweiligen unabhängigen Patentanspruchs.

Derartige Verfahren und Vorrichtungen sind bekannt und werden beispielsweise in fotografischen Printern eingesetzt, in denen die Kopiervorlage, die zum Beispiel durch Positiv- oder Negativfilme gebildet sein kann, ausgemessen wird, um die erforderlichen Kopierlichtmengen für die nachfolgende Aufbelichtung auf Kopiermaterial, beispielsweise Fotopapier, zu ermitteln. Die Ausmessung des Films erfolgt üblicherweise so, dass der Film in vielen einzelnen Messpunkten mit Licht beaufschlagt wird, welches den zu messenden Film durchdringt. Das durch den Film transmittierte Licht wird empfangen und die Transmissivität des Films wird mit Hilfe der Lichtmenge, die den Film im jeweiligen Messpunkt beaufschlagt, und mit Hilfe der durch den jeweiligen Messpunkt transmittierten Lichtmenge bestimmt. Üblicherweise erfolgt die Bestimmung der Lichtmengen mit Hilfe von Fotodioden, die das empfangene Licht in ein der Lichtmenge entsprechendes elektrisches Signal wandeln.

Die Tendenz bei der Ausmessung solcher Kopiervorlagen (Filme) geht hin zu immer höherer Auflösung der Vorlage. Dies bedeutet praktisch, dass jedes einzelne Bildfeld in immer mehr einzelnen Messpunkten ausgemessen wird. Dadurch wird die Lichtmenge, die den Film in den einzelnen Messpunkten durchdringt, immer kleiner. Dementsprechend verkleinert sich auch das von der Fotodiode erzeugte elektrische Signal (Fotostrom). Zusätzlich werden auch die Messintervalle, also die Messzeiten, in denen die einzelnen Messpunkte ausgemessen werden, immer kürzer.

Eine Verstärkung des Ausgangssignals mit Hilfe einer Operationsverstärkerschaltung (Op-Amp-Schaltung), die in ihrem Gegenkopplungszweig einen Widerstand enthält, wirft Probleme auf. Eine solche Verstärkerschaltung muss parallel zum Gegenkopplungswiderstand nämlich noch mit einem Kondensator versehen werden, damit die unvermeidbare Kapazitäten der Fotodiode (Sperrschichtkapazität etc.) kompensiert werden können und so ein Überschwingen des Ausgangssignals der Verstärkerschaltung vermieden wird. Ein weiterer Grund für einen solchen Kondensator im Gegenkopplungszweig ist das endliche Verstärkungs-Bandbreite-Produkt des Operationsverstäkers, denn auf diese Weise wird auch ein definierter Frequenzgang über die zu messende Bandbreite erzeugt.

Nachteilig dabei ist allerdings, dass der durch den Widerstand verursachte Rauschstrom, der ja sowohl von der Grösse des Widerstands als auch von der zu messenden Signalbandbreite abhängt, so gross ist, dass bei akzeptablen Signalverstärkungen (also bei grossem Gegenkopplungswiderstand) ein brauchbares Signal-Rausch-Verhältnis so gut wie gar nicht mehr erzielt werden kann. Da die Kapazität des Gegenkopplungskondensators nämlich klein gehalten werden muss, kann die Einschwingzeit der OpAmp-Schaltung nur noch über die Grösse des Gegenkopplungswiderstands beeinflusst werden. Die Einschwingzeit muss aber sehr klein sein, da bei einer hohen Auflösung der Vorlage in kurzer Zeit viele einzelne Messpunkte auf der Vorlage ausgemessen werden müssen und dabei das Ausgangssignal der OpAmp-Schaltung eingeschwungen sein muss. Demzufolge muss der Gegenkopplungswiderstand möglichst klein gewählt werden, was aber zur Folge hat, dass der von ihm verursachte Rauschstrom so gross ist, dass ein brauchbares Signal-Rausch-Verhältnis so gut wie gar nicht mehr erzielt werden kann bzw. das Messignal gar nicht aus dem Rauschen erkennbar ist. Zudem ist bei dieser Betrachtung das Eigenrauschen des Operationsverstärkers (OpAmp) selbst noch gar nicht berücksichtigt, das zusätzlich zum Widerstandsrauschen noch hinzukommt.

Es wurde daher eine Verstärkerschaltung vorgeschlagen, die nicht durch die nachteiligen Eigenschaften solcher Widerstände limitiert wird. Zu diesem Zweck ist bei dieser Verstärkerschaltung im Gegenkopplungszweig nur noch ein Kondensator vorgesehen. Das Ausgangssignal dieser Verstärkerschaltung (Integrator) ist dann ein Messignal, das nicht mehr dem Fotostrom, sondern dem zeitlichen Integral darüber, also der in der Fotodiode erzeugten Ladung proportional ist. Zu Beginn einer Messung muss allerdings jeweils der Kondensator entladen werden, um eine Anfangsbedingung zu schaffen, die unabhängig von der Vorgeschichte der Schaltung ist, um eine Verfälschung des Messergebnisses aufgrund von noch vorhandenen Restenergien im Kondensator zu vermeiden. Dieses Entladen des Kondensators erfolgt mit Hilfe eines MOSFET-Schalters. Eine derartige Schaltung ist aus DE-A-2446610 bekannt. Wegen unvermeidbarer Schaltkapazitäten eines solchen MOSFET-Schalters (Gate-Drain-Kapazität etc.) wird allerdings eine Ladung in den Eingang der Verstärkerschaltung transportiert, die einen grossen Offset am Ausgang der Verstärkerschaltung verursacht. Dieser Offset ist nicht bei jedem Schaltvorgang gleich gross, d.h. es entstehen gewisse Schwankungen des Offsets, ein sogenanntes Schaltrauschen. Es sind zwar Methoden bekannt, wie der Offset weitgehend beseitigt werden kann. Das Schaltrauschen kann jedoch auf diese Art nicht beseitigt werden, so dass insbesondere bei kleinen zu messenden Lichtmengen und dementsprechend kleinen elektrischen Signalen der Fotodiode und zusätzlich kurzen Integrationszeiten aufgrund der grossen Anzahl von Messpunkten auf dem Film, somit also auch kleinen Messignalen, auf diese Weise auch kaum bzw. so gut wie gar nicht ein zuverlässiges Signal für die empfangene Lichtmenge erzeugt werden kann.

Es ist daher eine Aufgabe der Erfindung, eine Messung von kleinen Lichtmengen und dementsprechend kleinen elektrischen Signalen der Fotodiode bzw. kleinen Messignalen nach der Integration der elektrischen Signale der Fotodiode zu ermöglichen, die auch bei einem derartigen vorhandenen Schaltrauschen eine zuverlässige Messung der von dem Empfänger, insbesondere von einer Fotodiode, empfangenen Lichtmenge ermöglichen. Dies soll auch bei kurzen Messzeiten, wie sie beispielsweise bei hohen Auflösungen und dementsprechend vielen Messpunkten der zu messenden Vorlage erforderlich sind, möglich sein. Zusätzlich soll die Messung von der Vorgeschichte unabhängig sein, um Verfälschungen des Messergebnisses zu vermeiden.

Verfahrensmässig wird diese Aufgabe dadurch gelöst, dass in einem ersten Zeitausschnitt des Messintervalls ein erstes Mittelwertsignal gebildet wird, das dem Mittelwert des Messignals (also des einfach integrierten Signals) über diesen ersten Zeitausschnitt entspricht, dass noch im gleichen Messintervall in einem zweiten Zeitausschnitt gleicher Dauer wie der erste ein zweites Mittelwertsignal gebildet wird, das dem Mittelwert des Messignals über diesen zweiten Zeitausschnitt entspricht, dass ein Differenzsignal gebildet wird, das der Differenz dieser beiden Mittelwertsignale entspricht und ein Mass für die empfangene Lichtmenge ist, und dass dieses Differenzsignal zur weiteren Signalverarbeitung weitergeführt wird. Das erste Mittelwertsignal ist ein Mass für die Ladungsmenge, die im ersten Zeitausschnitt des Messintervalls in der Fotodiode erzeugt wird, das zweite Mittelwertsignal ein Mass für die Ladungsmenge, die im zweiten Zeitausschnitt in der Fotodiode erzeugt wird. Das Differenzsignal entspricht somit einer Ladungsmengendifferenz, die in einem definierten Zeitraum aufgetreten ist, mithin also einem Strom, der proportional zur empfangenen Lichtmenge ist. Das vorhandene Rauschen der Fotodiode und des Verstärkers (OpAmp) wird durch die jeweilige Integration über einen Zeitausschnitt und anschliessende Subtraktion bei der Differenzbildung der Mittelwertsignale reduziert. Das Schaltrauschen wird durch die Differenzbildung der Mittelwertsignale reduziert.

In einer zweckmässigen Ausgestaltung des Verfahrens wird das jeweilige Mittelwertsignal durch Integrieren des Messignals gebildet.

Dies kann zweckmässigerweise derart erfolgen, dass in dem ersten Zeitausschnitt des Messintervalls das Messignal zunächst invertiert und dann integriert wird, dass zwischen dem Ende des ersten Zeitausschnitts und dem Beginn des zweiten Zeitausschnitts das so gebildete Mittelwertsignal gehalten wird, und dass in dem zweiten Zeitausschnitt des Messintervalls das Messignal, ohne dass es vorher invertiert wird, zu dem gehaltenen Mittelwertsignal hinzuintegriert wird.

Es kann allerdings auch derart erfolgen, dass in dem ersten Zeitausschnitt des Messintervalls das Messignal integriert wird, dass zwischen dem Ende des ersten Zeitausschnitts und dem Beginn des zweiten Zeitausschnitt das so gebildete Mittelwertsignal gehalten wird, und dass in dem zweiten Zeitausschnitt des Messintervalls dass Messignal zunächst invertiert und dann zu dem gehaltenen Mittelwertsignal hinzuintegriert wird.

Eine zweckmässige Variante des Verfahrens ist dadurch gekennzeichnet, dass das gebildete Differenzsignal noch während des Messintervalls einem Halteglied zugeführt wird, in dem das Differenzsignal gesondert gehalten wird, bis im darauffolgenden Messintervall dem Halteglied ein neues Differenzsignal zugeführt wird.

Um das Differenzsignal einfach und zuverlässig weiterverarbeiten zu können, wird es zunächst digitalisiert und anschliessend zur weiteren Signalverarbeitung weitergeführt.

Vorrichtungsmässig wird diese Aufgabe dadurch gelöst, dass Mittel vorgesehen sind, welche in einem ersten Zeitausschnitt des Messintervalls ein Mittelwertsignal erzeugen, das dem Mittelwert des Messignals über den ersten Zeitausschnitt entspricht, dass Mittel vorgesehen sind, die noch im gleichen Messintervall in einem zweiten Zeitausschnitt gleicher Dauer wie der erste ein zweites Mittelwertsignal erzeugen, das dem Mittelwert des Messignals über den zweiten Zeitausschnitt entspricht, dass Mittel vorgesehen sind, die ein Differenzsignal erzeugen, das der Differenz dieser beiden Mittelwertsignale entspricht und ein Mass für die empfangene Lichtmenge ist, und dass eine Signalverarbeitungseinheit vorgesehen ist, der das Differenzsignal zur weiteren Verarbeitung zugeführt ist. Das erste Mittelwertsignal ist ein Mass für die Ladungsmenge, die im ersten Zeitausschnitt des Messintervalls in der Fotodiode erzeugt wird, das zweite Mittelwertsignal ein Mass für die Ladungsmenge, die im zweiten Zeitausschnitt in der Fotodiode erzeugt wird. Das Differenzsignal entspricht somit einer Ladungsmengendifferenz, die in einem definierten Zeitraum aufgetreten ist, mithin also einem Strom, der proportional zur empfangenen Lichtmenge ist. Das vorhandene Rauschen von Fotodiode und Verstärker (OpAmp) wird durch die jeweilige Integration über einen Zeitausschnitt und das Schaltrauschen durch die anschliessende Subtraktion bei der Differenzbildung der Mittelwertsignale reduziert.

Um einen definierten und von der Vorgeschichte unabhängigen Ausgangszustand herzustellen, weist in einer zweckmässigen Ausgestaltung der Vorrichtung die Integratorschaltung, die während eines Messintervalls das Messignal erzeugt, einen Schalter auf, der zu Beginn eines Messintervalls die Integratorschaltung in ihren Ausgangszustand zurücksetzt. Dieser Schalter ist in vorteilhafter Weise durch einen MOSFET-Transistorschalter gebildet, kann aber ebensogut durch einen JFET-Transistorschalter gebildet sein.

In einer weiteren vorteilhaften Ausgestaltung der erfindungsgemässen Vorrichtung umfassen die Mittel zur Erzeugung des jeweiligen Mittelwertsignals eine Steuerung, die für den jeweiligen Zeitausschnitt ein Freigabesignal für eine weitere Integratorschaltung erzeugt, die in dem jeweiligen Zeitausschnitt des Messintervalls das Messignal integriert und so das jeweilige Mittelwertsignal erzeugt.

In einer Weiterbildung der Vorrichtung ist eine Inverterschaltung vorgesehen, die über einen Schalter, der durch ein von der Steuerung erzeugtes Einschaltsignal betatigbar ist, in Signalflussrichtung betrachtet vor der Integratorschaltung, die das jeweilige Mittelwertsignal erzeugt, in den Signalweg einschaltbar ist. Diese invertiert nach dem von der Steuerung erzeugten Freigabesignal für den ersten Zeitausschnitt das Messignal zunächst, bevor die nachfolgende Integratorschaltung dieses invertierte Messignal dann zum Erzeugen des ersten Mittelwertsignals integriert. Die Steuerung erzeugt zwischen dem Ende des ersten Zeitausschnitts und dem Beginn des zweiten Zeitausschnitts ein Haltesignal für die Integratorschaltung, so dass diese das erzeugte erste Mittelwertsignal hält. Nach dem von der Steuerung erzeugten Freigabesignal für den zweiten Zeitausschnitt integriert die nachfolgende Integratorschaltung das nichtinvertierte Messignal zu dem gehaltenen Mittelwertsignal hinzu. So wird das Differenzsignal der beiden Mittelwertsignale direkt gebildet.

In einer anderen Weiterbildung der Vorrichtung ist eine Inverterschaltung vorgesehen, die über einen Schalter, der durch ein von der Steuerung erzeugtes Einschaltsignal betätigbar ist, in Signalflussrichtung betrachtet vor der Integratorschaltung, die das jeweilige Mittelwertsignal erzeugt, in den Signalweg einschaltbar ist. Nach dem von der Steuerung erzeugten Freigabesignal integriert die Integratorschaltung das nichtinvertierte Messignal zum Erzeugen des ersten Mittelwertsignals. Die Steuerung erzeugt zwischen dem Ende des ersten und dem Beginn des zweiten Zeitausschnitts ein Haltesignal für die Integratorschaltung, so dass diese das erzeugte Mittelwertsignal hält. Nach dem Einschaltsignal für die Inverterschaltung und dem Freigabesignal für den zweiten Zeitausschnitt invertiert die Inverterschaltung das Messignal zunächst, bevor die nachfolgende Integratorschaltung dieses invertierte Signal dann zu dem gehaltenen Mittelwertsignal hinzuintegriert. So wird das Differenzsignal der beiden Mittelwertsignale ebenfalls direkt gebildet.

In einer vorteilhaften Weiterbildung der Vorrichtung ist der Schalter am Ausgang der Inverterschaltung vorgesehen. Der Schalter verbindet in einer ersten Schalterstellung diesen Ausgang mit dem Eingang der nachfolgenden Integratorschlatung und leitet so das invertierte Messignal an den Eingang der nachfolgenden Integratorschaltung. In einer zweiten Schalterstellung läuft der Schalter leer und leitet kein Signal an den Eingang der nachfolgenden Integratorschaltung und in einer dritten Schalterstellung verbindet der Schalter den Eingang der Inverterschaltung mit dem Eingang der zweiten Integratorschaltung und leitet so das nichtinvertierte Messignal an den Eingang der nachfolgenden Integratorschaltung.

In einer vorteilhaften Ausgestaltung der Vorrichtung ist ein separates Halteglied vorgesehen, dessen Eingang über ein von der Steuerung erzeugtes Speichersignal das Differenzsignal noch im Messintervall zugeführt ist. Dieses Halteglied hält das seinem Eingang zugeleitete Differenzsignal an seinem Ausgang, bis im darauffolgenden Messintervall seinem Eingang ein neues Differenzsignal zugeführt wird.

In einer vorteilhaften Weiterbildung ist dieses Halteglied durch eine Sample-and-Hold-Schaltung gebildet, die an ihrem Eingang mit einem Schalter versehen ist, der durch das Speichersignal gesteuert in einer ersten Schalterstellung der Sample-and-Hold-Schaltung das zu haltende Differenzsignal zuleitet, und der in einer zweiten Schalterstellung den Eingang der Sample-and-Hold-Schaltung leerlaufen lässt.

In einer weiteren vorteilhaften Ausgestaltung ist am Ausgang der Integratorschaltung ein Schalter vorgesehen, der durch die Steuerung betätigbar ist und der in einer ersten Schalterstellung diese Integratorschaltung in ihren Ausgangszustand zurücksetzt, der in einer zweiten Schalterstellung leerläuft, und der in einer dritten Schalterstellung den Ausgang dieser Integratorschaltung mit dem Eingang des nachfolgenden Halteglieds verbindet.

Schliesslich ist in einer weiteren vorteilhaften Ausgestaltung das Differenzsignal dem Eingang eines Analog-Digital-Wandlers zugeführt, dessen Ausgang mit der Signalverarbeitungseinheit verbunden ist.

Im folgenden wird die Erfindung anhand der Zeichnung näher erläutert Es zeigen in teilweise schematischer Darstellung:
- Fig. 1: ein Ausführungsbeispiel der erfindungsgemässen Vorrichtung,
- Fig. 2: ein Ausführungsbeispiel der ersten Integratorschaltung der Fig. 1,
- Fig. 3: den zeitlichen Verlauf des Messignals nach der ersten Integratorschaltung, und
- Fig. 4: die zeitlichen Signalverläufe nach den jeweiligen Schaltungen und die entsprechenden Schalterstellungen.

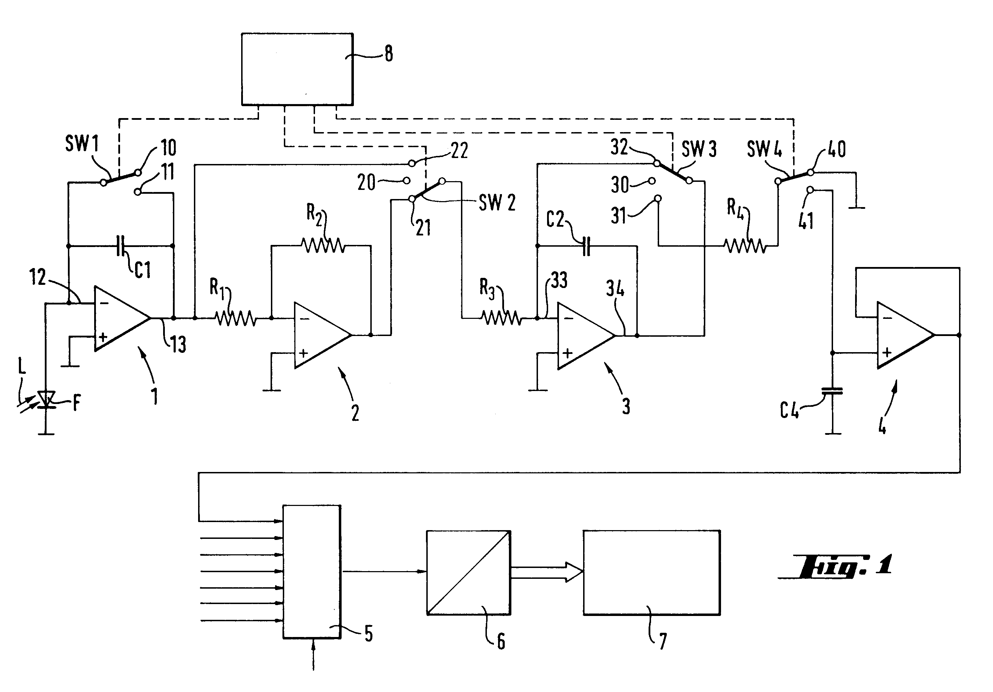

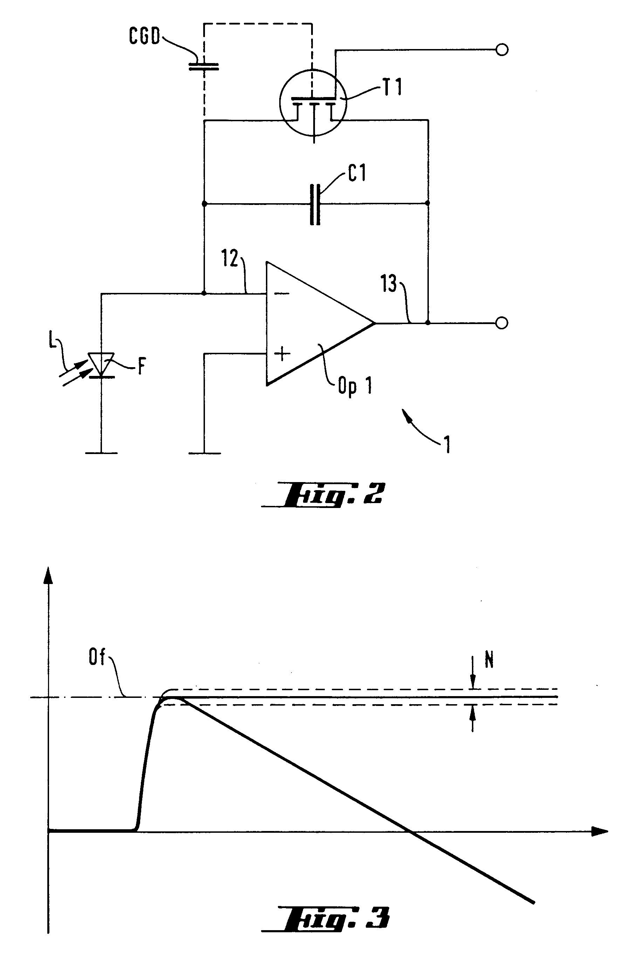

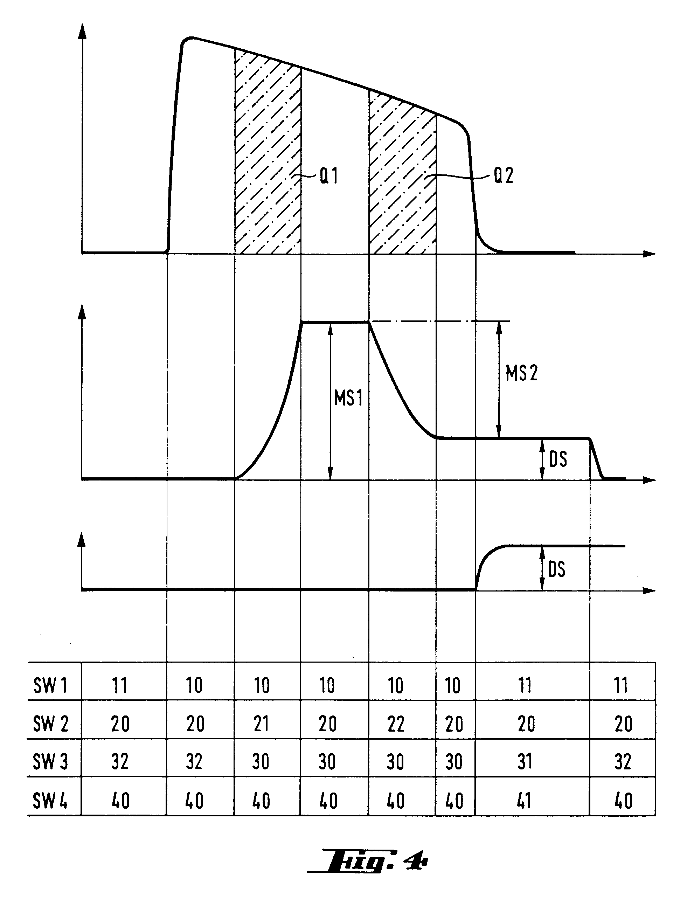

Im folgenden soll die Funktionsweise der Schaltung in Fig. 1 erläutert werden, wobei bei Bedarf auch auf Details der Schaltung verwiesen ist, wie beispielsweise auf die in Fig. 2 gezeigte erste Integratorschaltung, sowie auf Signalverläufe und Schalterstellungen, die in Fig. 3 und Fig. 4 dargestellt sind.

In Fig. 1 ist ein Ausführungsbeispiel der erfindungsgemässen Vorrichtung in Form einer vereinfacht dargestellten Schaltung gezeigt. Die Schaltung umfasst eine Fotodiode F, eine erste Integratorschaltung 1, eine Inverterschaltung 2, eine weitere Integratorschaltung 3, ein Halteglied 4, einen Multiplexer 5, einen Analog-Digital-Wandler 6, eine Signalverarbeitungsschaltung 7, mehrere Schalter SW1,SW2,SW3,SW4, sowie eine Steuerung 8 zum Betätigen dieser Schalter.

Vor Beginn eines jeden Messintervalls muss die gesamte Schaltung zunächst in einen definierten Ausgangszustand versetzt werden, der von der Vorgeschichte, insbesondere auch von Auswirkungen aus dem vorangegangenen Messintervall, unabhängig ist. Zu diesem Zweck leitet die Steuerung 8 jeweils ein Steuersignal zu den Schaltern SW1 und SW3, die mit Hilfe dieser Steuersignale betätigt werden. Im folgenden wird in einem solchen Fall davon gesprochen, "dass die Steuerung 8 den jeweiligen Schalter betätigt". Die Steuerung 8 betätigt also den Schalter SW1 derart, dass er in eine Position 11 gebracht wird, in welchem der Kondensator C1 im Gegenkopplungszweig kurzgeschlossen ist. Ebenso betätigt die Steuerung 8 den Schalter SW3 in eine Position 32, so dass der Kondensator C2 im Gegenkopplungszweig der Integratorschaltung 3 kuuzgeschlossen ist. Die Schalter SW2 und SW4 befinden sich dabei in den Schalterstellungen 20 und 40 (Schalterstellungen in der ersten Spalte der Tabelle der Schalterstellungen in Fig. 4). Diese Schalterstellungen sind in der Tabelle der Schalterstellungen aufgezeigt, die in Fig. 4 unter dem zeitlichen Verlauf des Signals nach der ersten Integratorschaltung 1 bzw. nach der zweiten Integratorschaltung 3 bzw. nach dem Halteglied 4 dargestellt ist.

Von diesem Ausgangszustand ausgehend wird der Beginn des Messintervalls dadurch ausgelöst, dass die Steuerung 8 den Schalter SW1 betätigt und in die Schalterstellung 10 bewegt (zweite Spalte der Schalterstellungen in Fig. 4). Der Schalter SW1 kann dabei so realisiert sein, wie es in der Detaildarstellung der ersten Integratorschaltung in Fig. 2 gezeigt ist, nämlich durch einen MOSFET-Transistorschalter T1. Durch ein Freigabesignal am Gate-Anschluss des Transistors T1 wird der Kurzschluss des Kondensators C1 aufgehoben. Dieses Spannungssignal hat allerdings wegen der unvermeidbaren Gate-Drain-Kapazität CGD des Transistors T1 zur Folge, dass eine Ladung in den Eingang 12 des Operartionsverstärkers Op1 fliesst, die am Ausgang 13 der ersten Integratorschaltung eine Offsetspannung Of zur Folge hat, die in Fig. 3 zu erkennen ist. Diese Offsetspannung Of ist nicht bei jedem Schaltvorgang gleich gross, so dass ein gewisses Schaltrauschen auftritt, das durch den strichlierten Streifen N in Fig. 3 angedeutet ist. Der durch das Licht L in der Fotodiode F (Fig. 2) erzeugte Fotostrom hat an diesem Ausgang einen zeitlichen Signalverlauf zur Folge, der in Fig. 3 durch den Verlauf der abfallenden Gerade angedeutet ist. Da es sich bei der beschriebenen Detailschaltung um eine Integratorschaltung 1 handelt, ist das Ausgangssignal ein Mass für die in der Fotodiode F durch das Licht L erzeugte Ladung.

Der zeitliche Signalverlauf am Ausgang der Integratorschaltung 1 während eines Messintervalls ist auch ganz oben in Fig. 4 noch einmal dargestellt. Nach dem Auslösen des Messintervalls durch Betätigung des Schalters SW1 befindet sich der Schalter SW1 in der Schalterstellung 10, Schalter SW2 in der Schalterstellung 20, Schalter SW3 in der Schalterstellung 32, und Schalter SW4 in der Schalterstellung 40 (zweite Spalte der Tabelle in Fig. 4).

Zu Beginn des ersten Zeitausschnitts des Messintervalls, der durch die dritte Spalte in Fig. 4 angedeutet ist, betätigt die Steuerung 8 den Schalter SW2 (Einschaltsignal für die Inverterschaltung 2) und bringt ihn aus Schalterstellung 20 in Schalterstellung 21 (Fig. 1), so dass das Ausgangssignal der ersten Integratorschaltung 1 zunächst von der Inverterschaltung 2 invertiert wird und anschliessend am Eingang 33 der weiteren Integratorschaltung 3 anliegt Gleichzeitig betätigt die Steuerung 8 auch den Schalter SW3 (Freigabesignal) und bringt ihn aus Schalterstellung 32 in Schalterstellung 30, wodurch der Kondensator C2 im Gegenkopplungszweig der Integratorschaltung 3 wirksam wird. Die Integratorschaltung 3 integriert somit in diesem Zeitausschnitt das an ihrem Eingang 33 anliegende Signal zu einem parabelförmigen Ausgangssignal. Der Verlauf des Ausgangssignals dieser weiteren Integratorschaltung 3 ist in der zweiten Zeile der Fig. 4 dargestellt, unterhalb des (invertierten) Ausgangssignals der ersten Integratorschaltung 1. Im ersten Zeitausschnitt der Messintervalls, also in der dritten Spalte der Fig. 4, erkennt man den parabelförmigen Verlauf dieses Ausgangssignals. Dieses Ausgangssignal ist ein Mass für die Fläche Q1 (Fig. 4). Diese Fläche Q1 ist aber wiederum ein Mass für den Mittelwert des Ausgangssignals der ersten Integratorschaltung 1 über den ersten Zeitausschnitt, mithin ein Mass für den Mittelwert der Ladung über diesen ersten Zeitausschnitt. Der Endwert des Ausgangssignals der zweiten Integratorschaltung 3 über den ersten Zeitausschnitt des Messintervalls wird daher im folgenden als erstes Mittelwertsignal MS1 bezeichnet.

Zum Ende dieses ersten Zeitausschnitts betätigt die Steuerung 8 den Schalter SW2 (Haltesignal) und bringt ihn aus Schalterstellung 21 in Schalterstellung 20, wie in der vierten Spalte der Fig. 4 erkennbar ist. Dies ist der Zeitraum zwischen dem ersten und dem zweiten Zeitausschnitt des Messintervalls. In diesem Zeitraum hält die Integratorschaltung 3 an ihrem Ausgang 34 das im ersten Zeitausschnitt erzeugte Mittelwertsignal MS1. Die Schalter SW1,SW3 und SW4 befinden sich dabei in den Schalterstellungen 10,30 und 40.

Zu Beginn des zweiten Zeitausschnitts des Messintervalls, der durch die fünfte Spalte in Fig. 4 angedeutet ist, betätigt die Steuerung 8 den Schalter SW2 erneut und bringt ihn aus Schalterstellung 20 in Schalterstellung 22 (Fig. 1), so dass das Ausgangssignal der ersten Integratorschaltung 1 nichtinvertiert am Eingang 33 der weiteren Integratorschaltung 3 anliegt. Die Integratorschaltung 3 integriert somit in diesem Zeitausschnitt das an ihrem Eingang 33 anliegende Signal zu dem gehaltenen Mittelwertsignal MS1 hinzu. Der zeitliche Verlauf des Ausgangssignals der Integratorschaltung 3 ist in der zweiten Zeile der Fig. 4 dargestellt, unterhalb des Ausgangssignals der ersten Integratorschaltung 1. Im zweiten Zeitausschnitt der Messintervalls, also in der fünften Spalte der Fig. 4, erkennt man den erneut parabelförmigen Verlauf des Ausgangssignals. Die Fläche Q2 ist wiederum ein Mass für den Mittelwert MS2 des Ausgangssignals der ersten Integratorschaltung 1 über den zweiten Zeitausschnitt, mithin ein Mass für den Mittelwert der Ladung über diesen zweiten Zeitausschnitt. Der Endwert des Ausgangssignals der zweiten Integratorschaltung 3 über den zweiten Zeitausschnitt ist ein Mass für die Differenz der beiden Mittelwertsignale MS1 und MS2 und wird daher als Differenzsignal DS bezeichnet. Dieses Differenzsignal ist also ein Mass für die Differenz zweier Ladungsmengen in der Fotodiode F in einem definierten Zeitraum, mithin ein Mass für den Fotostrom Gleichzeitig wird durch die Integration über jeweils einen Zeitausschnitt und die anschliessende Differenzbildung das statistisch verteilte Rauschen, das in beiden Zeitausschnitten dem Messignal überlagert ist, zumindest so stark verringert, dass gute Signal-Rausch-Abstände am Ausgang 34 der Integratorschaltung 3 erreicht werden können, die eine sichere Weiterverarbeitung des Differenzsignals DS ermöglichen.

Nach Beendigung des zweiten Zeitausschnitts der Messintervalls, also in der sechsten Spalte der Fig. 4, bringt die Steuerung 8 den Schalter SW2 wieder in Stellung 20, während sich die Schalter SW1, SW3 und SW4 nach wie vor in den Schalterstellungen 10,30 und 40 befinden. Am Ausgang 34 der Integratorschaltung 3 liegt also nach wie vor das Differenzsignal DS an.

Um dieses Differenzsignal DS dem in Form einer Sample-and-Hold-Schaltung realisierten Halteglied 4 zuzuleiten, betätigt die Steuerung 8 anschliessend die Schalter SW3 und SW4 (Speichersignal) und bringt sie in die Schalterstellungen 31 und 41. Dies ist in der siebten Spalte der Fig. 4 wie auch in dem zeitlichen Verlauf des Ausgangssignals des Halteglieds 4 (dritte Zeile der Fig. 4, siebte Spalte) erkennbar. Durch diese Betätigung des Schalters SW4 wird das Differenzsignal dem Eingangskondensator C4 der Sample-and-Hold-Schaltung 4 zugeführt. Gleichzeitig betätigt die Steuerung 8 auch den Schalter SW1 schliesst den Integrationskondensator C1 der ersten Integratorschaltung 1 kurz.

Nachdem das Differenzsignal DS der Sample-and-Hold-Schaltung 4 zugeführt ist, wird noch der Integrationskondensator C2 der Integratorschaltung 3 durch Betätigen des Schalters SW3 kurzgeschlossen, d.h. Schalter SW3 wird in die Schalterstellung 32 gebracht. Dies ist in der achten und letzten Spalte der Fig. 4 zu erkennen. Damit ist die gesamte Schaltung wieder in dem Ausgangszustand, der zu Anfang der Funktionsbeschreibung der Schaltung beschrieben ist, d.h. die Schalter SW1,SW2,SW3 und SW4 befinden sich jetzt wieder in den Schalterstellungen 11,20,32 und 40, wie in der ersten Spalte der Fig. 4, also im Ausgangszustand.

Das Differenzsignal DS liegt am Ausgang der Sample-and-Hold-Schaltung 4 an, bis ein neues Differenzsignal dem Eingang der Sample-and-Hold-Schaltung zugeführt wird. Das jeweilige am Ausgang des Multiplexers 5 anliegende Signal ist dem Eingang des Analog-Digital-Wandlers 6 zugeführt, die das analoge Differenzsignal digitalisiert. Der Ausgang des Analog-Digital-Wandlers 6 ist mit der Signalverarbeitungseinheit 7 verbunden, die das digitalisierte Signal weiterverarbeitet.

In einer praktischen Ausgestaltung der Schaltung kann als Fotodiode beispielsweise eine Fotodiode oder ein Fotodiodenarray vom Typ S 23 19-35Q der Firma Hamamatsu verwendet werden. Als Operationsverstärker sind beispielsweise Operationsverstärker vom Typ TL 074 der Firma Texas Instruments für die Inverterschaltung 2 und die Integratorschaltung 3 geeignet, für die erste Integratorschaltung 1 ist beispielsweise ein Operationsverstärker vom Typ LF 356 der Firma National Semiconductors besonders geeignet. Die Kondensatoren können beispielsweise zu C1= 2.2 pF, C2= 1.5 nF, und C4= 1.5 nF bemessen sein, die einzelnen Widerstände R₁ und R₂ der Inverterschaltung 2 können beispielsweise jeweils 10 kΩ betragen. Der Vorwiderstand R₃ am Eingang der Integratorschaltung 3 kann beispielsweise 3,6 kΩ betragen. Der Widerstand R₄ am Eingang der Sample-and-Hold-Schaltung 4 kann beispielsweise zu 100 Ω gewählt werden. Für den Multiplexer 5 und der Analog-Digital-Wandler 6 können an sich bekannte und handelsübliche Bausteine verwendet werden.

Als Variante zur oben beschriebenen Schaltung ist zum Beispiel denkbar, dass für die Erzeugung des ersten Mittelwertsignals und für die Erzeugung des zweiten Mittelwertsignals jeweils ein separater Signalzweig mit einer separaten Integratorschaltung vorgesehen ist, die im jeweiligen Zeitausschnitt das Messignal integriert. In einem dieser Zweige kann der Integratorschaltung eine Inverterschaltung vor- bzw. nachgeschaltet sein, so dass eines der Mittelwertsignale invertiert vorliegt. Anschliessend werden diese beiden Signale invertiert. Es ist selbstverständlich, dass auch beide Mittelwertsignale invertiert oder nichtinvertiert vorliegen können und dann die Differenz aus beiden Signalen gebildet werden kann. Als weitere Variante der oben beschriebenen Funktionsweise der Schaltung könnte auch anstelle der Invertierung des Messignals im ersten Zeitausschnitt und der Nichtinvertierung im zweiten Zeitausschnitt eine Nichtinvertierung im ersten Zeitausschnitt und eine Invertierung im zweiten Zeitausschnitt erfolgen. Besonders geeignet sind solche Schaltungen für den Einsatz in Verbindung mit Spektralfotometern, bei denen beispielsweise derartige kleine Lichtsignale auftreten können, die zusätzlich nur für eine sehr kurze Zeit für eine Messung zur Verfügung stehen. Derartige Anforderungen werden wegen einer erwünschten hohen Auflösung der Vorlage, also einer grossen Anzahl Messpunkte, die in möglichst kurzer Zeit (z.B. im Bereich von einigen »s) gemessen werden sollen bzw. müssen, gestellt. Diese Anforderungen können von der erfindungsgemässen Vorrichtung erfüllt und entsprechend kleine Lichtmengen verarbeitet werden.

## Patentansprüche

1. Verfahren zur Messung kleiner Lichtmengen, bei welchem die zu messende Lichtmenge empfangen und in ein elektrisches Signal gewandelt wird, das während eines Messintervalls zu einem Messignal integriert wird, dadurch gekennzeichnet, dass in einem ersten Zeitausschnitt des Messintervalls ein erstes Mittelwertsignal (MS1) gebildet wird, das dem Mittelwert des Messignals über diesen ersten Zeitausschnitt entspricht, dass noch im gleichen Messintervall in einem zweiten Zeitausschnitt gleicher Dauer wie der erste ein zweites Mittelwertsignal (MS2) gebildet wird, das dem Mittelwert des Messignals über diesen zweiten Zeitausschnitt entspricht, dass ein Differenzsignal (DS) gebildet wird, das der Differenz dieser beiden Mittelwertsignale entspricht und ein Mass für die empfangene Lichtmenge ist, und dass dieses Differenzsignal (DS) zur weiteren Signalverarbeitung weitergeführt wird.

2. Verfahren nach Anspruch 1, dadurch gekennzeichnet, dass das jeweilige Mittelwertsignal (MS1,MS2) durch Integrieren des Messignals gebildet wird.

3. Verfahren nach Anspruch 2, dadurch gekennzeichnet, dass in dem ersten Zeitausschnitt des Messintervalls das Messignal zunächst invertiert und dann integriert wird, dass zwischen dem Ende des ersten Zeitausschnitts und dem Beginn des zweiten Zeitausschnitts das so gebildete Mittelwertsignal (MS1) gehalten wird, und dass in dem zweiten Zeitausschnitt des Messintervalls das Messignal, ohne dass es vorher invertiert wird, zu dem gehaltenen Mittelwertsignal (MS1) hinzuintegriert wird.

4. Verfahren nach Anspruch 2, dadurch gekennzeichnet, dass in dem ersten Zeitausschnitt des Messintervalls das Messignal integriert wird, dass zwischen dem Ende des ersten Zeitausschnitts und dem Beginn des zweiten Zeitausschnitts das so gebildete Mittelwertsignal (MS1) gehalten wird, und dass in dem zweiten Zeitausschnitt des Messintervalls dass Messignal zunächst invertiert und dann zu dem gehaltenen Mittelwertsignal (MS1) hinzuintegriert wird.

5. Vorrichtung zur Messung kleiner Lichtmengen, mit einem Lichtempfänger, insbesondere einer Fotodiode (F), der das empfangene Licht in ein elektrisches Signal wandelt, und mit einer Integratorschaltung (1), die das elektrische Signal während eines Messintervalls zu einem Messignal integriert, dadurch gekennzeichnet, dass Mittel vorgesehen sind, welche in einem ersten Zeitausschnitt des Messintervalls ein Mittelwertsignal (MS1) erzeugen, das dem Mittelwert des Messignals über den ersten Zeitausschnitt entspricht, dass Mittel vorgesehen sind, die noch im gleichen Messintervall in einem zweiten Zeitausschnitt gleicher Dauer wie der erste ein zweites Mittelwertsignal (MS2) erzeugen, das dem Mittelwert des Messignals über den zweiten Zeitausschnitt entspricht, dass Mittel vorgesehen sind, die ein Differenzsignal (DS) erzeugen, das der Differenz dieser beiden Mittelwertsignale (MS1,MS2) entspricht und ein Mass für die empfangene Lichtmenge ist, und dass eine Signalverarbeitungseinheit (7) vorgesehen ist, der das Differenzsignal (DS) zur weiteren Verarbeitung zugeführt ist.

6. Vorrichtung nach Anspruch 5, dadurch gekennzeichnet, dass die Integratorschaltung (1), die während eines Messintervalls das Messignal erzeugt, einen Schalter (SW1) aufweist, der zu Beginn eines Messintervalls die Integratorschaltung (1) in ihren Ausgangszustand zurücksetzt.

7. Vorrichtung nach einem der Ansprüche 5 oder 6, dadurch gekennzeichnet, dass die Mittel zur Erzeugung des jeweiligen Mittelwertsignals eine Steuerung (8) umfassen, die für den jeweiligen Zeitausschnitt ein Freigabesignal für eine weitere Integratorschaltung (3) erzeugt, die in dem jeweiligen Zeitausschnitt des Messintervalls das Messignal integriert und so das jeweilige Mittelwertsignal (MS1,MS2) erzeugt.

8. Vorrichtung nach Anspruch 7, dadurch gekennzeichnet, dass eine Inverterschaltung (2) vorgesehen ist, die über einen Schalter (SW2), der durch ein von der Steuerung (8) erzeugtes Einschaltsignal betätigbar ist, in Signalflussrichtung betrachtet vor der Integratorschaltung (3), die das jeweilige Mittelwertsignal (MS1,MS2) erzeugt in den Signalweg einschaltbar ist, und die nach dem von der Steuerung (8) erzeugten Freigabesignal für den ersten Zeitausschnitt das Messignal zunächst invertiert, bevor die nachfolgende Integratorschaltung (3) dieses invertierte Messignal dann zum Erzeugen des ersten Mittelwertsignals (MS1) integriert, dass die Steuerung (8) zwischen dem Ende des ersten Zeitausschnitts und dem Beginn des zweiten Zeitausschnitts ein Haltesignal für die Integratorschaltung (3) erzeugt, so dass diese das erzeugte erste Mittelwertsignal (MS1) hält, und dass nach dem von der Steuerung (8) erzeugten Freigabesignal für den zweiten Zeitausschnitt die nachfolgende Integratorschaltung (3) das nichtinvertierte Messignal zu dem gehaltenen Mittelwertsignal (MS1) hinzuintegriert.

9. Vorrichtung nach Anspruch 7, dadurch gekennzeichnet, dass eine Inverterschaltung (2) vorgesehen ist, die über einen Schalter (SW2), der durch ein von der Steuerung (8) erzeugtes Einschaltsignal betätigbar ist, in Signalflussrichtung betrachtet vor der Integratorschaltung (3), die das jeweilige Mittelwertsignal erzeugt, in den Signalweg einschaltbar ist, dass nach dem von der Steuerung (8) erzeugten Freigabesignal die Integratorschaltung (3) das nichtinvertierte Messignal zum Erzeugen des ersten Mittelwertsignals (MS1) integriert, dass die Steuerung (8) zwischen dem Ende des ersten und dem Beginn des zweiten Zeitausschnitts ein Haltesignal für die Integratorschaltung (3) erzeugt, so dass diese das erzeugte Mittelwertsignal (MS1) hält, und dass nach dem Einschaltsignal für die Inverterschaltung (2) und dem Freigabesignal für den zweiten Zeitausschnitt die Inverterschaltung (2) das Messignal zunächst invertiert, bevor die nachfolgende Integratorschaltung (3) dieses invertierte Signal dann zu dem gehaltenen Mittelwertsignal (MS1) hinzuintegriert.

10. Vorrichtung nach Anspruch 8 oder 9, dadurch gekennzeichnet, dass der Schalter (SW2) am Ausgang der Inverterschältung vorgesehen ist, und dass der Schalter (SW2) in einer ersten Schalterstellung (21) diesen Ausgang mit dem Eingang der nachfolgenden Integratorschaltung (3) verbindet und so das invertierte Messignal an den Eingang der nachfolgenden Integratorschaltung (3) leitet, dass der Schalter (SW2) in einer zweiten Schalterstellung (20) leerläuft und kein Signal an den Eingang der nachfolgenden Integratorschaltung (3) leitet, und dass der Schalter (SW2) in einer dritten Schalterstellung (22) den Eingang der Inverterschaltung (2) mit dem Eingang der Integratorschaltung (3) verbindet und so das nichtinvertierte Messignal an den Eingang der nachfolgenden Integratorschaltung (3) leitet.

## Claims

1. A process for the measurement of small quantities of light, in which the light quantity to be measured is received and converted into an electrical signal that is integrated during a measuring interval to produce a measuring signal, which process comprises forming in a first time segment of the measuring interval a first average value signal (MS1) corresponding to the average value of the measuring signal over said first time segment, forming within the same measuring interval, in a second time segment of the same duration as the first time segment, a second average value signal (MS2) corresponding to the average value of the measuring signal over said second time segment, forming a difference signal (DS) which corresponds to the difference of said two average value signals and is a measure of the quantity of light received, and passing on said difference signal (DS) for further signal processing.

2. A process according to claim 1, wherein the respective average value signal (MS1, MS2) is formed by integrating the measuring signal.

3. A process according to claim 2, wherein in the first time segment of the measuring interval the measuring signal is first inverted and then integrated, between the end of the first time segment and the beginning of the second time segment the average value signal (MS1) formed in that manner is held, and in the second time segment of the measuring interval the measuring signal is integrated, without prior inversion, onto the average value signal (MS1) being held.

4. A process according to claim 2, wherein in the first time segment of the measuring interval the measuring signal is integrated, between the end of the first time segment and the beginning of the second time segment the average value signal (MS1) formed in that manner is held, and in the second time segment of the measuring interval the measuring signal is first inverted and then integrated onto the average value signal (MS1) being held.

5. An apparatus for measuring small quantities of light, comprising a light receiver, especially a photodiode (F), which converts the light received into an electrical signal, and an integrator circuit (1) that integrates the electrical signal during a measuring interval to produce a measuring signal, wherein means are provided that generate in a first time segment of the measuring interval an average value signal (MS1) corresponding to the average value of the measuring signal over the first time segment, means are provided that generate within the same measuring interval, in a second time segment of the same duration as the first time segment, a second average value signal (MS2) corresponding to the average value of the measuring signal over the second time segment, means are provided that generate a difference signal (DS) which corresponds to the difference of said two average value signals (MS1, MS2) and is a measure of the quantity of light received, and a signal processing unit (7) is provided to which the difference signal (DS) is passed for further processing.

6. An apparatus according to claim 5, wherein the integrator circuit (1) that generates the measuring signal during a measuring interval comprises a switch (SW1) that, at the beginning of a measuring interval, resets the integrator circuit (1) to its initial state.

7. An apparatus according to either claim 5 or claim 6, wherein the means for generating the respective average value signal comprise a control (8) which generates for the respective time segment a release signal for a further integrator circuit (3) that integrates the measuring signal in the respective time segment of the measuring interval and in that manner generates the respective average value signal (MS1, MS2).

8. An apparatus according to claim 7, wherein an inverter circuit (2) is provided which, by means of a switch (SW2) actuated by a switch-on signal generated by the control (8), can be connected into the signal path upstream, in the direction of signal flow, of the integrator circuit (3) that generates the respective average value signal (MS1, MS2), and which, following the release signal for the first time segment generated by the control (8), first inverts the measuring signal before the subsequent integrator circuit (3) then integrates that inverted measuring signal in order to generate the first average value signal (MS1), and wherein the control (8) generates a holding signal for the integrator circuit (3) between the end of the first time segment and the beginning of the second time segment so that said integrator circuit (3) holds the generated first average value signal (MS1), and, following the release signal for the second time segment generated by the control (8), the subsequent integrator circuit (3) integrates the non-inverted measuring signal onto the average value signal (MS1) being held.

9. An apparatus according to claim 7, wherein an inverter circuit (2) is provided which, by means of a switch (SW2) actuated by a switch-on signal generated by the control (8), can be connected into the signal path upstream, in the direction of signal flow, of the integrator circuit (3) that generates the respective average value signal, following the release signal generated by the control (8) the integrator circuit (3) integrates the non-inverted measuring signal in order to generate the first average value signal (MS1), the control (8) generates a holding signal for the integrator circuit (3) between the end of the first time segment and the beginning of the second time segment so that said integrator circuit (3) holds the generated average value signal (MS1), and, following the switch-on signal for the inverter circuit (2) and the release signal for the second time segment, the inverter circuit (2) first inverts the measuring signal before the subsequent integrator circuit (3) then integrates that inverted signal onto the average value signal (MS1) being held.

10. An apparatus according to either claim 8 or claim 9, wherein the switch (SW2) is provided at the output of the inverter circuit and in a first switch position (21) the switch (SW2) connects that output to the input of the subsequent integrator circuit (3) and thereby passes the inverted measuring signal to the input of the subsequent integrator circuit (3), in a second switch position (20) the switch (SW2) is open and passes no signal to the input of the subsequent integrator circuit (3), and in a third switch position (22) the switch (SW2) connects the input of the inverter circuit (2) to the input of the integrator circuit (3) and thereby passes the non-inverted measuring signal to the input of the subsequent integrator circuit (3).

## Revendications

1. Procédé de mesure de faibles quantités de lumière, dans lequel la quantité de lumière à mesurer est reçue et convertie en un signal électrique qui est intégré en formant un signal de mesure pendant un intervalle de mesure, procédé caractérisé en ce que l'on forme, au cours d'une première période de l'intervalle de mesure, un premier signal (MS1) de valeur moyenne, qui correspond à la valeur moyenne du signal de mesure au cours de cette première période ; on forme, dans encore le même intervalle de mesure, mais dans une seconde période de même durée que la première, un second signal (MS2) de valeur moyenne, qui correspond à la valeur moyenne du signal de mesure au cours de cette seconde période, on forme un signal de différence (DS), qui correspond à la différence entre ces deux signaux de valeur moyenne et qui est une mesure de quantité de lumière reçue, et on injecte ce signal de différence (DS) dans un élément de traitement complémentaire de signaux.

2. Procédé selon la revendication 1, caractérisé en ce que l'on forme chacun des signaux de valeur moyenne (MS1, MS2) en intégrant le signal de mesure correspondant.

3. Procédé selon la revendication 2, caractérisé en ce que, dans la première période de l'intervalle de mesure ; on inverse d'abord le signal de mesure, puis on l'intègre ; entre la fin de cette première période et le début de la seconde, on retient en attente le signal (MS1) de valeur moyenne formé de cette manière et, dans la seconde période de l'intervalle de mesure, on ajoute à ce signal de mesure (MS1), retenu en attente, le signal de mesure sans l'inverser préalablement.

4. Procédé selon la revendication 2, caractérisé en ce que, dans la première période de l'intervalle de temps, on intègre le signal de mesure ; entre la fin de cette première période et le début de la seconde, on retient en attente le signal (MS1) de valeur moyenne formé de cette manière ; et, dans la seconde période de l'intervalle de mesure, on inverse d'abord le signal de mesure, puis on l'intègre et on l'ajoute au signal (MS1) de valeur moyenne retenu en attente.

5. Dispositif de mesure de faibles quantités de lumière, ce dispositif comportant un photorécepteur, notamment une photodiode (F) qui convertit la lumière reçue en un signal électrique, ainsi qu'un circuit intégrateur (1) qui intègre ce signal électrique en formant un signal de mesure au cours d'un intervalle de mesure, dispositif caractérisé en ce qu'il comporte des éléments qui produisent, au cours d'une première période de l'intervalle de mesure, un signal (MS1) de valeur moyenne qui correspond à la valeur moyenne du signal de mesure au cours de cette première période ; des éléments qui, dans toujours le même intervalle de mesure, mais dans une seconde période de même durée que la première, produisent un second signal (MS2) de valeur moyenne, qui correspond à la valeur moyenne du signal de mesure au cours de cette seconde période ; des éléments qui délivrent un signal (DS) de différence correspondant à la différence entre ces deux signaux (MS1, MS2) de valeur moyenne et représentant une mesure de la quantité de lumière reçue ; et un élément (7) de traitement de signal, dans lequel le signal (DS) de différence est injecté pour subir un traitement complémentaire.

6. Dispositif selon la revendication 5, caractérisé en ce que le circuit intégrateur (1), qui produit les signaux de mesure pendant un intervalle de mesure, inclut un commutateur (SW1) qui le ramène à son état initial au début de chacun de ces intervalles de mesure.

7. Dispositif selon l'une des revendications 5 et 6, caractérisé en ce que les éléments qui produisent les signaux de valeur moyenne respectifs comprennent un circuit de commande (8), qui émet pour la période correspondante un signal de libération d'un autre circuit intégrateur (3), lequel intègre le signal de mesure au cours de la période correspondante de l'intervalle de mesure, en produisant le signal (MS1, MS2) de valeur moyenne correspondant.

8. Dispositif selon la revendication 7, caractérisé en ce qu'il comporte un circuit inverseur (2), qui peut être intercalé sur le trajet des signaux, en amont -dans le sens du passage de ces signaux- du circuit intégrateur (3) qui produit les signaux (MS1, MS2) de valeur moyenne, par l'entremise d'un commutateur (SW2) actionné par un signal de fermeture délivré par le circuit de commande (8) et qui, lorsque ce circuit de commande (8) a émis le signal de libération relatif à la première période, inverse le signal de mesure avant que le circuit intégrateur (3) suivant intègre ce signal inversé en produisant le premier signal (MS1) de valeur moyenne, le circuit de commande (8) émettant, entre la fin de la première période et le début de la seconde, un signal d'arrêt de ce circuit intégrateur (3), si bien que celui-ci retient ce premier signal (MS1) de valeur moyenne et, quand le circuit de commande (8) a émis le signal de libération relatif à la seconde période, ledit circuit intégrateur (3) intègre ce signal de mesure non inversé en l'ajoutant audit signal (MS1) de valeur moyenne retenu en attente.

9. Dispositif selon la revendication 7, caractérisé en ce qu'il comporte un circuit inverseur (2), qui peut être intercalé sur le trajet des signaux, en amont -dans le sens du passage de ces signaux- du circuit intégrateur (3) qui produit les signaux (MS1, MS2) de valeur moyenne, par l'entremise d'un commutateur (SW2) actionné par un signal de fermeture délivré par le circuit de commande ; en ce que lorsque ce circuit de commande (8) a délivré le signal de libération, ce circuit intégrateur (3) intègre le signal de mesure -non inversé- en délivrant le premier signal (MS1) de valeur moyenne ; en ce que ce circuit de commande (8) émet, entre la fin de la première période et le début de la seconde, un signal d'arrêt dudit circuit intégrateur (3), si bien que celui-ci retient en attente ce signal (MS1) de valeur moyenne produit et en ce que, après le signal de branchement du circuit inverseur (2) et le signal de libération relatif à la seconde période, ce circuit inverseur (2) inverse d'abord le signal de mesure avant que le circuit intégrateur (3) intègre ce signal inversé et l'ajoute au signal (MS1) de valeur moyenne retenu en attente.

10. Dispositif selon la revendication 8 ou 9, caractérisé en ce que le commutateur (SW2) est prévu à la sortie du circuit inverseur ; dans une première position (21) le commutateur (SW2) connecte cette sortie à l'entrée du circuit intégrateur (3) d'aval, en appliquant le signal de mesure inversé à cette entrée du circuit intégrateur (3) d'aval ; dans une seconde position (20), ce commutateur (SW2) est ouvert et ne transmet aucun signal à l'entrée dudit circuit intégrateur (3) ; et, dans une troisième position (22), il connecte l'entrée du circuit inverseur (2) à cette entrée du circuit intégrateur (3) en appliquant le signal de mesure, non inversé, à ladite entrée du circuit intégrateur (3).
